# EUROPÄISCHE PATENTSCHRIFT

(11) **EP 1 720 193 B1**
(45) Veröffentlichungstag und Bekanntmachung des Hinweises auf die Patenterteilung: **23.04.2008**
(21) Anmeldenummer: 06004324.7
(22) Anmeldetag: 03.03.2006
(51) Int. Cl.: H01J 37/24

(54) **Anordnung für die Regelung der Elektronenstrahlleistung einer Elektronenstrahlkanone**
Arrangement for regulating the electron beam output of an electron gun
Dispositif pour la régulation de la puissance de rayonnement électronique d'un canon à électrons

(30) Priorität: 04.05.2005 DE 102005020815
(43) Veröffentlichungstag der Anmeldung: 08.11.2006
(73) Patentinhaber: Applied Materials GmbH & Co. KG, 63755 Alzenau (DE); ALD Vacuum Technologies GmbH, 63450 Hanau (DE)
(72) Erfinder: Klemm, Günter, 61667 Nidda (DE); Thiede, Andreas, 01465 Dresden-Schönborn (DE); Schneider, Hans-Jürgen, 63607 Wächtersbach (DE)
(74) Vertreter: Schickedanz, Willi

(56) Entgegenhaltungen:
- DE-A1- 3 239 337
- US-A- 3 689 798
- US-A- 3 909 662
- US-A- 3 909 663
- US-B1- 6 590 216
- PATENT ABSTRACTS OF JAPAN Bd. 007, Nr. 036 (E-158), 15. Februar 1983 (1983-02-15) & JP 57 189445 A (NIPPON DENSHI KK), 20. November 1982 (1982-11-20)
- PATENT ABSTRACTS OF JAPAN Bd. 009, Nr. 035 (E-296), 14. Februar 1985 (1985-02-14) & JP 59 177845 A (NIPPON DENKI KK), 8. Oktober 1984 (1984-10-08)
- PATENT ABSTRACTS OF JAPAN Bd. 009, Nr. 220 (E-341), 6. September 1985 (1985-09-06) & JP 60 079654 A (NIPPON DENKI KK), 7. Mai 1985 (1985-05-07)

## Beschreibung

Die Erfindung betrifft eine Anordnung nach dem Oberbegriff des Patentsanspruchs 1. Elektronenstrahlkanonen werden vornehmlich zum Schmelzen, Schweißen, Bearbeiten und Verdampfen aller Art, vorzugsweise unter Vakuum, verwendet. Dabei ist es oft erforderlich, die Leistung des Elektronenstrahls an sich ändernde Bedingungen anzupassen.

Eine häufig verwendete Elektronenstrahlkanone ist die Drei-Elektroden-Elektronenstrahlkanone, die ein Filament, eine Blockkathode und eine Anode aufweist. Das Filament, auch Primärkathode genannt, besteht in der Regel aus einer Wolfram-Drahtwendel, durch die Strom fließt. Im Vakuum treten durch thermische Emission Elektronen aus der Oberfläche der Drahtwendel in hinreichender Menge aus. Vor dem Filament befindet sich die Blockkathode, auch Sekundärkathode genannt, die den Hochleistungs-Elektronenstrahl emittieren soll.

Dazu müssen aus der Blockkathode wesentlich mehr Elektronen emittiert werden, als dies beim Filament der Fall ist. Um diese Emissionsfähigkeit der Blockkathode zu erreichen, wird zwischen dem Filament und der Blockkathode eine elektrische Spannung, die so genannte Blockspannung, angelegt. Sie liegt in der Größenordnung von bis zu 3 kV.

Diese Blockspannung bewirkt das Entstehen eines Elektronenstrahls zwischen Filament und Blockkathode, welcher eine starke Erwärmung der Blockkathode zur Folge hat. Dies äußert sich optisch in einer hellen Leuchterscheinung. Die auf diese Weise aus der Blockkathode freigesetzten Elektronen können in einem zwischen Blockkathode und Anode angelegten elektrischen Feld kinetische Energie aufnehmen.

Das elektrische Feld wird in der Regel durch eine Spannung in der Größenordnung von 40 kV erzeugt. Die Blockkathode soll hierbei so viele Elektronen emittieren, wie zur Bereitstellung der gewünschten Strahlleistung erforderlich sind.

Soll die Emission der Elektronen konstant gehalten werden, muss auch die Temperatur der Block- oder Sekundärkathode konstant gehalten werden. Zum Konstanthalten der Emissionstemperatur der Sekundärkathode in durch Elektronenbombardement geheizten Elektronenstrahlkanonen für Elektronenstrahl-Schweiß-, -Schmelz- und -Bedampfungseinrichtungen ist bereits ein Verfahren bekannt (DD 70 674). Hierbei wird der Emissionsstrom der Primärkathode bei konstanter Beschleunigungsspannung zwischen Primärkathode und Sekundärkathode mittels einer von ihm abgeleiteten Regelgröße über den Heizstrom der Primärkathode geregelt, wobei der Heizstrom der Primärkathode über eine von ihm abgeleitete Regelgröße begrenzt wird. Der Emissionsstrom der Block- oder Sekundärkathode - die auch Hauptkathode genannt wird - wird hierbei weder erfasst noch geregelt.

Bei einer bekannten Schaltung zur Regelung der Betriebsparameter eines Elektronenstrahlerzeugers ist eine Regeleinrichtung für die Filamentkathode vorgesehen, die aus drei in Kaskadenordnung geschalteten Einzelreglern besteht (DE 23 25 808 C2). Bei diesen Einzelreglern handelt es sich um einen Heizstromregler, einen Emissionsstromregler und einen Strahlstromregler.

Hochleistungselektronen- und Strahlkanonen werden oft bei konstanter Spannung über längere Zeiträume und mit konstantem Emissionsstrom betrieben. Bedingt durch die große thermische Trägheit der Blockkathoden ist eine schnelle Leistungsvariation durch Temperaturänderung der Blockkathode nicht möglich. Schnelle Veränderungen der Elektronenstrahlleistung könnten durch eine negative Vorspannung eines Wehneltzylinders bewirkt werden. Da die Emissionsfläche der Blockkathode jedoch sehr groß ist, müsste die Wehneltspannung sehr hoch werden, um damit eine Leistungssteuerung zu erzielen (W. Dietrich, H. Ranke und H. Stumpp: Strahlführung und Leistungssteuerung von Elektronenstrahlkanonen bis 600 kW und deren Einsatz in der industriellen Produktion, Optik 7-2001, S. 11).

Eine schnelle Leistungsänderung könnte auch durch Variation der Beschleunigungsspannung erreicht werden, wenn die Kathode im Raumladungsbereich betrieben wird. Nachteilig bei dieser Methode wäre die gleichzeitig erforderliche Anpassung der Fokussierung an die veränderte Beschleunigungsspannung, um eine davon unabhängige Elektronenstrahlposition zu erhalten (W. Dietrich et al., a.a.O).

Weiterhin ist eine Einrichtung für Elektronenstrahlkanonen bekannt, die einen Regler aufweist, mit dem der Heizstrom und / oder der Emissionsstrom des Filaments regelbar ist (DE 40 31 286 A1). Der Regler weist hierbei einen Filamentheizstromregler und einen Emissionsstromregler auf, wobei dem Filamentheizstromzregler die Differenz zwischen Filamentheizstrom-Sollwert und Filamentheizstom-Istwert zugeführt wird, während dem Emissionsstromregler die Differenz zwischen dem Emissionsstrom-Sollwert und dem Emissionsstrom-Istwert zugeführt wird. Der Vorteil dieser Einrichtung besteht darin, dass die Filament-Heizung wahlweise über den Heizstrom oder den Emissionsstrom geregelt werden kann.

Außerdem ist auch noch ein Verfahren zur Regelung der Elektronenstrahlleistung von Elektronenquellen bekannt, mit dem eine Regelung der Nennleistung von Null bis 200 kW möglich ist (DE 102 42 538 A1). Die Elektronenquelle weist hierbei eine indirekt geheizte Kathode, eine Anode sowie eine Fokussierelektrode auf. Es sind mindestens zwei unabhängige Stellglieder vorgesehen, welche jeweils einen der Parameter Kathodentemperatur, Kathodenspannung, Fokussierelektrodenspannung und Kathoden-Anoden-Abstand als Stellparameter verändert.

Schließlich ist auch noch eine Einrichtung zur automatischen Regelung des Betriebszustands einer elektrothermischen Anlage mit einer Elektronenkanone bekannt, deren Hauptkathode durch ein von einer Hilfskathode emittiertem Elektronenbündel erhitzt wird (DE 19 35 710). Die Hauptkathode der Elektronenkanone wird hierbei von einer ersten Baueinheit und die Hilfskathode von einer zweiten Baueinheit gespeist. Außerdem ist ein Schaltungsteil zur Korrektur der Hauptkathodenheizung vorgesehen, der wenigstens mit einer der erwähnten Baueinheiten verbunden ist. Mit dieser bekannten Einrichtung kann die Stabilität des Betriebszustandes einer Elektronenstrahlanlage verbessert werden. Eine schnelle Änderung der Strahlleistung ist damit aber nicht verbunden.

Die Patentanmeldung US 6 590 216 B1 offenbart eine Anordnung für die Regelung der Elektronenstrahlleistung einer Elektronenstrahlkanone entsprechend dem Oberbegriff von Anspruch 1.

Der Erfindung liegt die Aufgabe zugrunde, die Strahlleistung einer Elektronenstrahlkanone schnell zu ändern.

Diese Aufgabe wird mit den Merkmalen des Patentanspruchs 1 gelöst.

Die Erfindung betrifft somit eine Anordnung für die Regelung der Elektronenstrahlleistung einer Elektronenstrahlkanone, die eine Filamentkathode, eine Blockkathode und eine Anode aufweist. Zwischen der Filamentkathode und der Blockkathode liegt eine erste Spannung an, während zwischen der Blockkathode und der Anode eine zweite Spannung anliegt. Mit Hilfe einer ersten Regelstrecke wird die Filamentkathode auf einen konstanten Stromwert geregelt, der eine Filamenttemperatur besitzt, welche für eine maximale Strahlleistung der Blockkathode ausreicht. Eine zweite Regelstrecke, die einen Blockleistungsregler enthält, der mit der Differenz zwischen Blockleistungs-Istwert und Blockleistungs-Sollwert beaufschlagt ist, regelt die Spannung zwischen der Filamentkathode und der Blockkathode.

Der mit der Erfindung erzielte Vorteil besteht insbesondere darin, dass keine drei Regler in Kaskadenschaltung vorgesehen sein müssen. Hierdurch wird die Regelung schneller und kann Störungen besser beherrschen. Außerdem vermindert sich die Kreisverstärkung, wodurch kleine Störungen in der Blockleistung weniger gravierende Wirkungen auf den Ausgang haben. Ferner wird die Blockleistung geregelt, welche die Temperatur besser repräsentiert als der Blockstrom.

Ein Ausführungsbeispiel der Erfindung ist in den Zeichnungen dargestellt und wird im Folgenden näher beschrieben.

Es zeigen:
- Fig. 1: eine erfindungsgemäße Regelanordnung;
- Fig. 2: eine Kurvendarstellung der Blockleistung über dem Emissionsstrom für die erfindungsgemäße Blockleistungsregelung gegenüber dem Heizstrom einer Drahtwendel über dem Emissionsstrom bei konventioneller Regelung gemäß DE 23 25 808 C2;
- Fig. 3: einen Emissionsstromsprung über der Zeit.

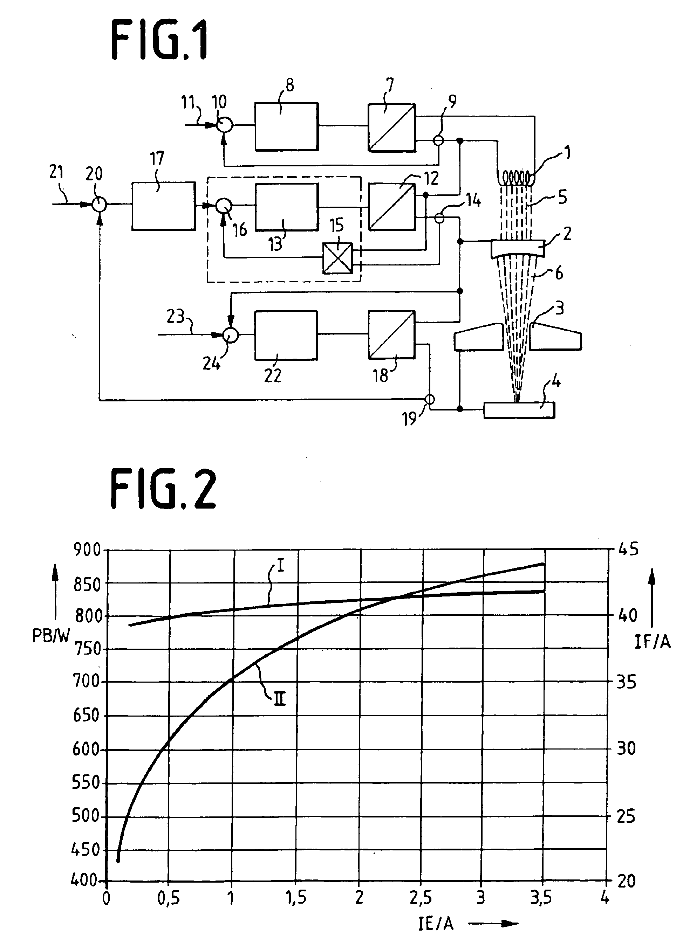

In der Fig. 1 ist auf der rechten Seite eine Elektronenstrahlkanone schematisch dargestellt. Man erkennt hierbei ein Filament bzw. eine Drahtkathode 1, eine Blockkathode 2, eine Anode 3 sowie einen Tiegel 4. Die Elektronen, die von der Filamentkathode 1 auf die Blockkathode 2 gelangen, sind mit der Bezugszahl 5 versehen, während diejenigen Elektronen, die von der Blockkathode 2 zum Tiegel 4 gelangen, mit der Bezugszahl 6 versehen sind. Die Filamentkathode 1 liegt an einer regelbaren Stromquelle 7. Wird der Strom dieser Stromquelle 7 erhöht, erhöht sich auch der Stromfluss durch die Filamentkathode 1, wodurch sich diese stärker erwärmt und mehr Elektronen emittiert. Die Regelung der Stromquelle 7 erfolgt durch einen Regler 8. Der Regler 8 regelt den Strom der Drahtkathode 1 auf einen konstanten Wert. So kann bei gleichen Umweltbedingungen eine nahezu konstante Temperatur der Drahtkathode 1 erzielt werden.

Eine Stromerfassung 9 misst den durch die Filamentkathode 1 fließenden Strom und gibt den so erfassten Strom-Istwert auf einen Vergleichspunkt 10, wo ein Drahtkathodenstrom-Sollwert 11 mit dem Drahtkathodenstrom-Istwert verglichen wird. Die Differenz von Strom-Istwert und Strom-Sollwert gelangt auf den Regler 8.

Der Strom durch die Filamentkathode 1 wird dabei so geregelt, dass die Filamentkathode 1 so viele Elektronen 5 emittiert, dass die Blockkathode 2 ihren maximal möglichen Elektronenstrom 6 emittieren kann. Dadurch, dass der Strom durch die Filamentkathode 1 auf einen festen Wert geregelt wird, ist der Emissionsstrom 6 der Blockkathode 2 unabhängig vom Zeitverhalten der Filamentkathode 1.

Die Spannung zwischen der Filamentkathode 1 und der Blockkathode 2 wird durch eine Spannungsquelle 12 bereitgestellt, die von einem Blockleistungsregler 13 angesteuert wird. Mit einer Stromerfassung 14 wird der Strom gemessen, der von der Spannungsquelle 12 geliefert wird. Es handelt sich hierbei um den Emissionsstrom der Filamentkathode 1. Dieser Strom wird in einem Multiplizierer 15 mit der Spannung der Spannungsquelle 12 multipliziert, so dass sich die elektrische Leistung errechnet. Diese Leistung wird dem Vergleichspunkt 16 zugeführt, der ein Signal aus einem Emissionsstromregler 17 erhält. Bei diesem Signal handelt es sich um ein Blockleistungs-Sollsignal für die Blockkathode 2. Der Ausgang des Reglers 17 gibt ein aus der Differenz von dem Emissionsstrom-Sollwert für die Blockkathode 2 und dem Emissionsstrom-Istwert für diese Blockkathode 2 gebildetes Signal ab. Bei konstanter Beschleunigungsspannung steht dieses Signal im Zusammenhang mit der Blockleistung, siehe Kurve II in Fig. 2. Deshalb kann es als Sollwert für den Blockleistungsregler 13 dienen. Der Regler 17 ist notwendig, um den Emissionsstrom der Blockkathode 2 zu regeln. Er wird auf das Regelverhalten der Emissionsstrecke der Blockkathode 2 angepasst. Die Temperatur der Blockkathode 2 bestimmt bei konstanter Beschleunigungsspannung den Emissionsstrom.

Für die Bereitstellung der Beschleunigungsspannung für die von der Blockkathode 2 emittierten Elektronen 6 ist eine Spannungsquelle 18 vorgesehen. Die Anode 3 und der Tiegel 4 liegen hierbei an gleichem elektrischem Potential. Der von dieser Spannungsquelle 18 gelieferte Strom wird von der Stromerfassung 19 gemessen und an den Vergleicher 20 gegeben, der mit einem Emissionsstrom-Sollwert bzw. Strahlstrom-Sollwert 21 beaufschlagt wird. Die Differenz zwischen Strom-Istwert und Strom-Sollwert wird auf den Regler 17 gegeben.

Die Spannungsquelle 18 wird von einem Regler 22 geregelt, der mit einem Signal beaufschlagt wird, das der Differenz zwischen einem Beschleunigungsspannungs-Istwert und einem Beschleunigungsspannungs-Sollwert 23 entspricht. Diese Differenz wird durch einen Vergleicher 24 ermittelt. Der Regler 22 regelt die Beschleunigungsspannung auf einen konstanten Wert. Der Anschluss an der Blockkathode 2 führt den Istwert der Spannung zwischen Blockkathode 2 und Anode 3, also die Beschleunigungsspannung, auf den Vergleichspunkt am Eingang des Reglers 22.

Für die Elektronenemission der Blockkathode 2 ist somit dem Emissionsstromregler 17 ein Blockleistungsregler 13 nachgeschaltet. Dessen Ausgang steuert die Spannungsquelle 12 für die Beschleunigungs- oder Blockspannung zwischen Filamentkathode 1 und Blockkathode 2. Aus Blockstrom und Blockspannung wird der Istwert der Blockleistung gebildet und dem Blockleistungsregler 13 zugeführt. Die Blockleistung steht hierbei im direkten Zusammenhang mit der Temperatur der Blockkathode 2, welche unter Einwirkung einer konstanten Beschleunigungsspannung die Emission bewirkt. Der Blockleistungsregler 13 regelt die Leistung der Blockkathode 2 in entsprechender Weise wie der Regler 17 den Emissionsstrom. Der Regler 13 muss allerdings wesentlich schneller als der Regler 17 reagieren. Er hat deshalb eine kürzere Nachstellzeit und eine andere Verstärkung als der Regler 17.

Es sind also bei dieser Anordnung nur zwei Regler 17, 13 in Reihe geschaltet. Die Regelung arbeitet dadurch stabiler, und es können größere Verstärkungen für eine höhere Genauigkeit eingestellt werden. Die Sollwerte an den Stellen 11, 21 und 23 werden von einem Operator über eine Bedienoberfläche der Elektronenstrahlanlage entsprechend den erforderlichen Prozessbedingungen eingegeben.

In der Fig. 2 ist die erfindungsgemäße Regelkennlinie II mit einer herkömmlichen Regelkennlinie I in Vergleich gesetzt. Die herkömmliche Regelkennlinie I zeigt die Abhängigkeit des Emissionsstroms IE der Blockkathode 2 von dem Heizstrom IF der Filamentkathode 1. Dagegen zeigt die erfindungsgemäße Regelkennlinie II die Abhängigkeit der Leistung PB der Blockkathode 2 vom Emissionsstrom IE der Filamentkathode 1.

Bei der herkömmlichen Regelkennlinie I führt eine geringe Änderung des Heizstroms IF der Filamentkathode 1 zu einer großen Änderung des Emissionsstroms IE der Blockkathode 2. Wird beispielsweise der Heizstrom IF von 40 A auf 41 A erhöht, so erhöht sich der Emissionsstrom IE von 0,5 A auf 1,5 A. Der Regelungsbereich ist dabei sehr eng und setzt erst bei ca. 39 A des Heizstroms der Filamentkathode 1 ein.

Bei der erfindungsgemäßen Regelkennlinie II wird dagegen ein größerer Bereich der Blockleistung PB verwendet, um die gleiche Änderung des Emissionsstroms IE zu erzielen. Dies führt zu einem stabileren Regelverhalten und höherer Regelgenauigkeit.

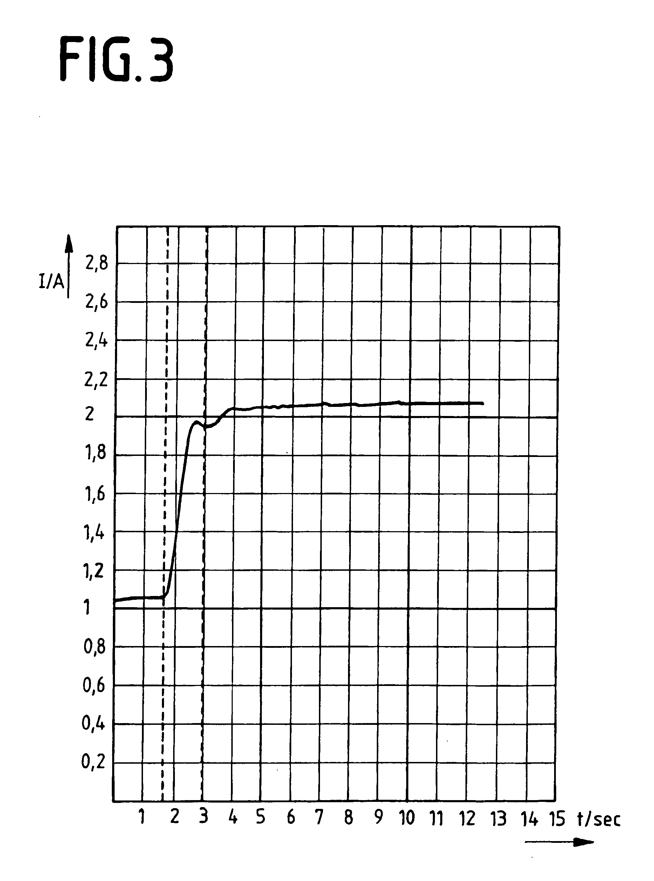

Die Fig. 3 zeigt, dass der Emissionsstrom der Blockkathode 2 bei einem Sollwertsprung innerhalb von weniger als einer Sekunde von einem Ampere auf zwei Ampere springen kann. Bei konstant gehaltenem Heizstrom der Filamentkathode 1 kann, verursacht etwa durch eine Erhöhung der Umgebungstemperatur bei steigender Blockleistung, die Blockspannung absinken. Durch die geringeren Blockspannungen werden, gerade bei größeren Leistungen, Block-Arcs vermieden.

## Patentansprüche

1. Anordnung für die Regelung der Etektronenstrahlleistung einer Elektronenstrahlkanone, wobei die Elektronenstrahlkanone eine Filamentkathode (1), eine Blockkathode (2) und eine Anode (3) aufweist und zwischen der Filamentkathode und der Blockkathode eine erste Spannung und zwischen der Blockkathode und der Anode eine zweite Spannung anliegt, wobei eine erste und eine zweite Regelstrecke vorgesehen sind, **dadurch gekennzeichnet, dass**
a) die erste Regelstrecke (8, 7) die Filamentkathode (1) auf einen konstanten Stromwert regelt, der eine Filamenttemperatur bewirkt, welche für eine maximale Strahlleistung der Blockkathode (2) ausreicht, und dass
b) die zweite Regelstrecke (17, 13, 12) einen Blockleistungsregler (13) enthält, der mit der Differenz zwischen Blockleistungs-Istwert und Blockleistungs-Sollwert beaufschlagt wird und die Spannung zwischen der Filamentkathode (1) und der Blockkathode (2) regelt.

2. Anordnung nach Anspruch 1, **dadurch gekennzeichnet, dass** die erste Regelstrecke (8, 7) einen Regler (8) aufweist, der mit der Differenz aus Filamentstrom-Sollwert und -Istwert beaufschlagt ist und der eine steuerbare Stromquelle (7) ansteuert.

3. Anordnung nach Anspruch 1, **dadurch gekennzeichnet, dass** die erste Spannung zwischen Filamentkathode (1) und Blockkathode (2) von einer Spannungsquelle (12) bereitgestellt wird, die von dem Blockleistungsregler (13) geregelt wird.

4. Anordnung nach Anspruch 1, **dadurch gekennzeichnet, dass** die zweite Spannung zwischen Blockkathode (2) und Anode (4) von einer regelbaren Spannungsquelle (18) geliefert wird, die von einem Regler (22) beaufschlagt wird, auf dessen Eingang die Differenz aus Beschleunigungsspannungs-Sollwert und -Istwert gegeben wird.

5. Anordnung nach Anspruch 1, **dadurch gekennzeichnet, dass** der Blockleistungs-Istwert von einem Multiplizierer (15) bereitgestellt wird, der die Ist-Spannung zwischen Filamentkathode (1) und Blockkathode (2) mit dem Ist-Emissionsstrom der Filamentkathode (1) multipliziert.

6. Anordnung nach Anspruch 1, **dadurch gekennzeichnet, dass** der Blockleistungs-Sollwert von einem Regler (17) bereitgestellt wird, der mit der Differenz zwischen dem Sollwert des Emissionsstroms der Blockkathode (2) und dem Istwert des Emissionsstroms der Blockkathode (2) beaufschlagt wird.

## Claims

1. Arrangement for the regulation of the electron beam power of an electron gun, wherein the electron gun comprises a filament cathode (1), a block cathode (2) and an anode (3), and between the filament cathode and the block cathode a first voltage is applied, and between the block cathode and the anode a second voltage is applied, wherein a first and a second closed-loop regulated system are provided, **characterized in that**
a) the first closed-loop regulated system (8, 7) regulates the filament cathode (1) to a constant current value, which causes a filament temperature sufficient for a maximum beam power of the block cathode (2) and that
b) the second closed-loop regulated system (17, 13, 12) includes a block power regulator (13) which is acted upon by the difference between instantaneous block power value and nominal block power value and which regulates the voltage between filament cathode (1) and the block cathode (2).

2. Arrangement as claimed in claim 1, **characterized in that** the first closed-loop regulated system (8, 7) includes a regulator (8), which is acted upon by the difference of nominal filament current value and instantaneous filament current value and which drives a controllable current source (7).

3. Arrangement as claimed in claim 1, **characterized in that** the first voltage between filament cathode (1) and block cathode (2) is provided by a voltage source (12), which is regulated by the block power regulator (13).

4. Arrangement as claimed in claim 1, **characterized in that** the second voltage between block cathode (2) and anode (4) is supplied by a regulatable voltage source (18), which is acted upon by a regulator (22) to whose input the difference of nominal acceleration voltage value and instantaneous acceleration voltage value is supplied.

5. Arrangement as claimed in claim 1, **characterized in that** the instantaneous block power value is provided by a multiplier (15), which multiplies the instantaneous voltage between filament cathode (1) and block cathode (2) by the instantaneous emission current of the filament cathode (1).

6. Arrangement as claimed in claim 1, **characterized in that** the nominal block power value is provided by a regulator (17), which is acted upon by the difference between the nominal value of the emission current of the block cathode (2) and the instantaneous value of the emission current of the block cathode (2).

## Revendications

1. Agencement pour le réglage de la puissance du faisceau électronique d'un canon à électrons, le canon à électrons présentant une cathode à filament (1), une cathode en bloc (2) et une anode (3) et une première tension s'appliquant entre la cathode à filament et la cathode en bloc et une seconde tension s'appliquant entre la cathode en bloc et l'anode, et un premier et un second tronçon de réglage étant prévus, **caractérisé en ce que**
a) le premier tronçon de réglage (8, 7) règle la cathode à filament (1) sur une valeur de courant constante, qui entraîne une température de filament qui est suffisante pour une puissance de faisceau maximale de la cathode en bloc (2), et **en ce que**
b) le second tronçon de réglage (17, 13, 12) contient un régulateur de puissance de bloc (13), qui est sollicité avec la différence entre la valeur réelle de la puissance de bloc et la valeur théorique de la puissance de bloc et règle la tension entre la cathode à filament (1) et la cathode en bloc (2).

2. Agencement selon la revendication 1, **caractérisé en ce que** le premier tronçon de réglage (8, 7) présente un régulateur (8) qui est sollicité avec la différence de la valeur théorique du courant de filament et de la valeur réelle et active une source de courant (7) contrôlable.

3. Agencement selon la revendication 1, **caractérisé en ce que** la première tension entre la cathode à filament (1) et la cathode en bloc (2) est fournie par une source de tension (12) qui est réglée par le régulateur de puissance de bloc (13).

4. Agencement selon la revendication 1, **caractérisé en ce que** la seconde tension entre la cathode en bloc (2) et l'anode (4) est fournie par une source de tension (18) réglable, qui est sollicitée par un régulateur (22), à l'entrée duquel est acheminée la différence entre la valeur théorique et la valeur réelle de la tension d'accélération.

5. Agencement selon la revendication 1, **caractérisé en ce que** la valeur réelle de la puissance de bloc est fournie par un multiplicateur (15), qui multiplie la tension réelle entre la cathode à filament (1) et la cathode de bloc (2) avec le courant d'émission réel de la cathode à filament (1)

6. Agencement selon la revendication 1, **caractérisé en ce que** la valeur théorique de la puissance de bloc est fournie par un régulateur (17) qui est sollicité avec la différence entre la valeur théorique du courant d'émission de la cathode en bloc (2) et la valeur réelle du courant d'émission de la cathode en bloc (2) .
